# EUROPÄISCHE PATENTSCHRIFT

(11) **EP 2 130 416 B1**
(45) Veröffentlichungstag und Bekanntmachung des Hinweises auf die Patenterteilung: **13.02.2013**
(21) Anmeldenummer: 08715998.4
(22) Anmeldetag: 23.02.2008
(51) Int. Cl.: H01M 2/02, H01M 2/10, H05K 1/02, B60R 21/0136

(54) **LEITERPLATTENSCHUTZ FÜR EINE BATTERIE**
CONDUCTOR PLATE PROTECTION FOR A BATTERY
DISPOSITIF DE PROTECTION DE CARTE DE CIRCUITS IMPRIMÉS DESTINÉ À UNE BATTERIE

(30) Priorität: 27.02.2007 DE 102007010738
(43) Veröffentlichungstag der Anmeldung: 09.12.2009
(73) Patentinhaber: Daimler AG, 70327 Stuttgart (DE)
(72) Erfinder: MEINTSCHEL, Jens, 73730 Esslingen (DE); SCHROETER, Dirk, 71364 Winnenden (DE)
(74) Vertreter: JENSEN & SON
(86) Internationale Anmeldenummer: PCT/EP2008/001447
(87) Internationale Veröffentlichungsnummer: WO 2008/104340

(56) Entgegenhaltungen:
- EP-A- 0 752 808
- EP-A- 1 063 872
- WO-A-2004/034754
- DE-A1- 1 591 134
- US-A- 5 123 538
- US-A1- 2004 252 476

## Beschreibung

Die Erfindung betrifft eine Batterie, insbesondere eine Lithium-Ionen-Batterie oder Nickel-Metallhydrid-Batterie, insbesondere eine Fahrzeugbatterie, insbesondere eine Batterie für ein Fahrzeug mit Hybridantrieb oder ein Brennstoffzellen-Fahrzeug, insbesondere eine Hochvolt-Batterie.

Nach dem Stand der Technik muss die bei Ladung und Entladung in den Zellen von Lithium-Ionen-Batterien (z.B. für Hybridantriebe oder Brennstoffzellen-Fahrzeuge) entstehende Wärme durch eine Kühlung abgeführt werden. Wegen der maximal zulässigen Zelltemperatur von ca. 50 °C wird die Kühlung über den Klimakreislauf des Fahrzeugs vorgenommen.

Nach dem Stand der Technik sind Batterien bekannt, bei denen Zellen vom Boden aus durch eine von Kältemittel durchströmte Kühlplatte gekühlt werden. In Längsrichtung der Zelle wird die Wärme durch separate Wärmeleitstäbe geleitet. Um die Wärme von den Zellen zu der Kühlplatte zu leiten befinden sich zwischen den Zellen Wärmeleitstäbe aus Aluminium, die in der Kühlplatte verankert sind und die Wärme in Längsrichtung der Zellen ableiten. Allerdings ist eine derartige mit Wärmeleitstäben versehene Kühlplatte und ebenso ein Hüllblech aufwendig und teuer. Die wärmetechnische Anbindung der Zellen an die Wärmeleitstäbe erfolgt durch Vergussmasse, mit welcher der Zellverbund ausgegossen ist. Die Vergussmasse übernimmt gleichzeitig die elektrische Isolation und fixiert die Zellen im Zellverbund. Ferner gleicht die Vergussmasse toleranzbedingte Spalten zwischen den Bauteilen des Zellverbunds aus. Als Vergussmasse wird beispielsweise Epoxydharz, Polyurethan oder Silikon verwendet. Die Vergussmasse besitzt somit gegenüber den sonstigen Bauteilen des Zellverbunds nur eine relativ geringe mechanische Festigkeit.

Auf die Kühlplatte ist außerdem ein mantelartiges Blech aufgesetzt, das die Zellen seitlich umschließt. Es dient zur Wärmeableitung und als Form für die Vergussmasse, mit der die Räume zwischen Zellen und Wärmeleitstäben ausgegossen werden. Der ganze Zellblock ist mit dem Hüllblech umgeben und wird mittels einer wärmeleitfähigen Vergussmasse ausgegossen. Dabei bildet das Hüllblech gleichzeitig die Vergießform.

Nach dem Verguss entsteht der so genannte Zellblock oder Zellverbund, eine massive Konstruktion, die im Batteriegehäuse befestigt wird. Nach dem Einbau des Innenlebens der Batterie wird der Gehäusedeckel durch Verschraubung, Vernietung, Verklebung oder Verschweißung befestigt. Das Gehäuse einer Batterie umfasst also typischerweise einen Boden, eine Seitenwand und einen Deckel.

Zum Verbinden der elektrischen Anschlußbereiche der Zellen sowie ggf. zum Überwachen der Funktion, z.B. Laden oder Stromentnahme, der Zellen einer Batterie, auf die sich die vorliegende Anmeldung bezieht, weist die Batterie eine Platine (Zellverbindungs- und/oder Überwachungsplatine) auf, die im Innern des Gehäuses im elektrischen Anschlussbereich der Zellen angeordnet ist.

Eine Platine ist ein Trägerelement für elektronische Bauteile. Sie wird auch als Leiterplatte oder gedruckte Schaltung bezeichnet und dient der mechanischen Befestigung und der elektrischen Verbindung von elektronischen Bauteilen. Die Verbindungsleitungen werden in der Regel durch Ätzen aus einer dünnen Schicht leitfähigen Materials auf einer isolierenden Grundplatte hergestellt und die Bauelemente werden auf diese Leiterbahnen gelötet.

Die Platine ist aufgrund ihrer Bauart ein bruchempfindliches Teil und wird daher im Deformationsfall des Gehäuses, z.B. bei einem Frontalcrash eines Kraftfahrzeugs mit einer entsprechenden Batterie, Belastungskräften ausgesetzt, die von der Deformationskraft auf das Gehäuse verursacht werden. Dadurch kann die Platine beschädigt oder zerstört werden, was auch Gefahren mit sich bringt. Beispielsweise können hohe Kurzschlussströme zu Überhitzungen führen oder Lichtbögen zu der Entzündung von Gemischen. Bei Hochvoltbatterien besteht auch die Gefahr, dass das Gehäuse unter Spannung gesetzt wird.

Nach dem Stand der Technik werden zum Schutz der Platinen in Batterien Isolationsplatten eingesetzt, die lediglich eine direkte Berührung von Gehäuse und stromführenden Teilen im Inneren des Gehäuses verhindern. Dabei kommt es zu Deformationen der Zellen einschließlich des Zellterminals und des Gehäuses und dem Abreißen von Zellverbindern. Da bei Hochvoltbatterien eine Spannung von ca. 120 Volt oder mehr vorliegt, kommt es zur Ausbildung von Lichtbögen und/oder zu einer Überlastung der Zellen.

Nachteilig bei den bekannten Batterien ist somit die hohe Belastung, die im Deformationsfall von dem Gehäuse auf die Platine wirkt und dadurch zu Schädigungen, Zerstörungen und Gefahren führen kann.

Der Erfindung liegt die Aufgabe zugrunde, eine Batterie mit einer verbesserten Deformationssicherheit, beispielsweise im Crashfall, zu schaffen.

Die Aufgabe wird erfindungsgemäß durch eine Batterie mit den Merkmalen des Anspruchs 1 gelöst. Bevorzugte Ausgestaltungen und Weiterbildungen der Erfindung ergeben sich aus den abhängigen Ansprüchen und der nachfolgenden Beschreibung mit zugehörigen Zeichnungen.

Ein erfindungsgemäße Batterie, insbesondere eine Lithium-Ionen-Batterie oder Nickel-Metallhydrid-Batterie, mit einem Gehäuse, einem in dem Gehäuse angeordneten Zellverbund aus Batteriezellen und einer Platine, die im Innern des Gehäuses im elektrischen Anschlussbereich der Zellen zum elektrischen Verbinden der Zellen angeordnet ist, weist also die Besonderheit auf, dass die Batterie im Innern des Gehäuses angeordnete Stützelemente aufweist, mit denen im Falle einer Deformation des Gehäuses durch eine von außen auf das Gehäuse einwirkende Deformationskraft, die zu einem Deformieren des Gehäuses in Richtung auf die Platine führt, die durch die Deformation des Gehäuses von dem Gehäuse auf die Platine ausgeübten Belastungskräfte zum Schutz der Platine abgestützt werden.

Die Stützelemente sind dabei vorteilhafterweise zum Vorbeiführen der Belastungskräfte um die Platine oder zum Hindurchführen der Belastungskräfte durch die Platine ausgebildet.

Eine vorteilhafte Ausführungsform besteht darin, dass die Stützelemente für die Kraftverteilung zum Absetzen mittels durch die Platine durchgehender Stützelementen auf dem Zellverbund ausgebildet sind. Die Stützelemente können für die Kraftverteilung zum großflächigen Absetzen des Gehäuses auf dem Zellverbund oder für die Kraftverteilung zum Absetzen mittels durch die Platine durchgehender Stützelemente auf dem Zellverbund ausgebildet sein.

Nach einem vorteilhaften Merkmal ist vorgesehen, dass die Stützelemente zum Ableiten der Belastungskräfte auf die der Platine zugewandte Seite des Zellverbunds ausgebildet sind.

Gemäß einer ersten vorteilhaften Weiterbildung ist vorgesehen, dass die Kraftleitung der Belastungskräfte mittels in der Platine beweglich eingelagerter Stützelemente erfolgt. Die Kraftleitung der Belastungskräfte kann aber auch mittels in der Platine fixierter Stützelemente erfolgen, wobei die Stützelemente beispielsweise durch eine Passung in der Platine fixiert oder in die Platine eingeklebt sind.

Die Stützelemente können vorteilhafterweise als Einzelelemente, beispielsweise als Stifte, oder als Flächenelement, beispielsweise als Platte, ausgebildet sein. Die Platte ist vorteilhafterweise auf der von dem elektrischen Anschlussbereich der Zellen abgewandten Seite der Platine angeordnet. Ferner kann die Platte die Platine durchdringende Stützen aufweisen.

Eine andere vorteilhafte Ausführungsform besteht darin, dass Platine zur Kraftleitung der Belastungskräfte auf der Platine eingearbeitete oder in die Platine integrierte Stützelemente aufweist. Dabei können die Stützelemente beispielsweise als Stützaugen oder als stabile elektrische Bauelemente, die auf der Platine angeordnet, beispielsweise Spulen, ausgebildet sein. Ferner können die Stützelemente auf der Seite der Platine angeordnet sein, die dem elektrischen Anschlussbereich der Zellen zugewandt ist, oder sowohl auf der Seite der Platine, die dem elektrischen Anschlussbereich der Zellen zugewandt ist, als auch auf der Seite der Platine, die von dem elektrischen Anschlussbereich der Zellen abgewandt ist, angeordnet sein.

Vorteilhafte Ausführungsformen bestehen darin, dass Stützelemente zur punktuellen, linienförmigen oder flächigen Lastverteilung innerhalb der Batterie ausgebildet sind.

Eine weitere vorteilhafte Ausgestaltung ist darin zu sehen, dass die Stützelemente zum Abstützen einer im wesentlichen waagrecht verlaufenden Deformationskraft bzw. Belastungskraft ausgebildet und hierzu im wesentlichen in waagrechter Orientierung, bezogen auf die Einbaulage der Batterie, ausgerichtet sind.

Durch die Erfindung werden folgende Vorteile erzielt:
- Auch bei einem Crash wird die elektrische Sicherheit durch eine Verteilung der Kraft innerhalb des Zellverbunds gewährleistet.
- Die Batterie kann in crashgefährdeten Bauräumen, beispielsweise eines Kraftfahrzeugs, eingebaut werden.
- Die Zell-Polanschlüsse werden geschützt.
- Die Zellverbinderplatinen werden vor Beschädigung oder Zerstörung geschützt, auch im Hinblick auf Leiterbahnen und Bauelemente.
- Zusätzliche aufwendige Verstärkungsmaßnahmen an dem Gehäuse können entfallen.
- Eine Hochvolt-Batterie für ein Hybrid-Kraftfahrzeug wird im Deformationsfall, z.B. beim Frontalcrash, nicht durch einen Kontakt zwischen Zellverbinder-Platinen und Batteriegehäuse eine elektrische Spannung auf dem Gehäuse führen.
- Die Gesamtdeformation wird sehr gering gehalten und Zellpole werden beim Kontakt des Batteriegehäuses mit der Zellverbinder-Platine nicht deformiert.
- Die Belastungskraft wird über einen breiten Zellverbund durch die Batterie geführt. Dadurch wird die Struktur des Batteriegehäuses entlastet.
- Kräfte können durch Platinen ohne deren Zerstörung oder Beschädigung mittels Stützelementen durchgeleitet werden.
- Das elektrische Layout von Zellverbinderplatinen wird geschützt. Die elektrische Isolation wird gewährleistet.
- Im Zellverbund werden zur Vermeidung von Kraftspitzen Druckkräfte aus dem Batteriegehäuse aufgenommen.
- Die Zellterminals werden vor Verformung, Beschädigung oder Zerstörung mittels Stützelementen zwischen Batteriegehäuse, Zellverbinder-Platine und Zellverbund geschützt.
- Elektrische Energiespeicher auf Zellbasis, z.B. Batteriezellen und Kondensatoren, werden in crashrelevenaten Fahrzeugzonen durch eine Kraftverteilung mittels Stützelementen innerhalb des Batteriegehäuses unter Nutzung des Zellverbundes zur Kraftübertragung geschützt.
- Stützelemente werden zur punktuellen, linienförmigen oder flächigen Lastverteilung innerhalb einer Batterie zu deren elektrischer und mechanischer Sicherheit und Stabilität eingesetzt.
- Stützelemente, die Bestandteil eines Platinendesigns sind oder separat Kräfte durch Platinen führen können, können als Crash-Schutzelemente genutzt werden.

Die Erfindung wird nachfolgend anhand in den Figuren dargestellter Ausführungsbeispiele näher erläutert. Die darin beschriebenen Besonderheiten können einzeln oder in Kombination miteinander eingesetzt werden, um bevorzugte Ausgestaltungen der Erfindung zu schaffen.

Dabei zeigen:
- Fig. 1: einen senkrechten Schnitt durch eine erfindungsgemäße Batterie.
- Fig. 2: als Einzelelemente ausgebildete Stützelemente.
- Fig. 3: ein als Flächenelement ausgebildetes Stützelement.
- Fig. 4: eine Platine mit integrierten Stützelmenten.

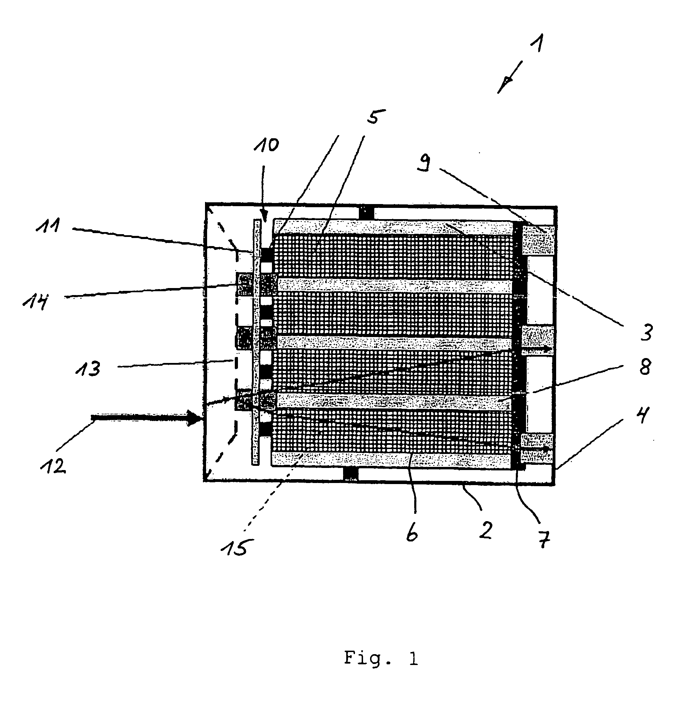

Die Fig. 1 zeigt einen senkrechten Schnitt durch eine erfindungsgemäße Batterie 1. Zu erkennen sind in das Gehäuse 2, das ein Innengehäuse 3 und ein Außengehäuse 4 umfasst, eingesetzte Zellen 5, beispielsweise Lithium-Ionen-Batteriezellen. Die Zellen 5 haben eine kreiszylindrische Außenkontur und sind mit den Längsachsen parallel zueinander in einem Zellverbund 6 angeordnet. Zum Erzielen einer raumsparenden Bauform sind die Zellen 5 in einer kompakten regelmäßigen Anordnung, ggf. mit einem geringen Abstand zwischen den Zellen 5, nebeneinander in dem Zellverbund 5 angeordnet. Die Zellen 5 können vom Boden aus durch eine von Kältemittel durchströmte Kühlplatte 7 gekühlt werden, die in intern verlegten Kühlschlangen von Kältemittel durchströmt wird. Zum Durchleiten einer Kühlflüssigkeit durch die Kühlschlange der Kühlplatte 7 weist die Kühlplatte 7 einen Kühlflüssigkeitsanschluss auf.

Der ganze Zellblock 5 kann mit einem Hüllblech umgeben sein und kann vor oder nach dem Einsetzen in das Batteriegehäuse 2 mit wärmeleitfähiger Vergussmasse 8 ausgegossen sein, die in Fig. 1 noch nicht eingefüllt ist. Die Vergussmasse 8 übernimmt gleichzeitig die elektrische Isolation und fixiert die Zellen 5 im Zellverbund 6. Der Zellverbund 6 ist durch Gegenlager 9 gegen das Gehäuse 2 abgestützt.

Die zwischen den Zellen 5 vorhandenen Spalten bzw. Zwischenräume werden mit Vergussmasse 8 ausgefüllt. Das Hüllblech dient gleichzeitig als Gießform beim Einfüllen der Vergussmasse 8. Der beim Vergießen mit Vergussmasse 8 gebildete Zellverbund 6 wird nach dem Verguss in das Batteriegehäuse 2 eingebaut. Geeignete Werkstoffe für die Vergussmasse 8 sind beispielsweise ein Epoxydharz, oder ein Hartschaum bzw. aushärtender Schaum, insbesondere ein Polyurethan-Schaum. Die Vergussmasse 8 ist vorzugsweise ein wärmeleitfähiges und/oder elektrisch isolierendes Material.

In dem elektrischen Anschlussbereich 10 der Zellen 5 ist eine Platine 11 (Zellverbindungsplatine) angeordnet. Es kann vorgesehen sein, dass die dem Gehäuse 2 zugewandte Seite der Platine 11 mit einer Vergussmasse 8 ausgegossen ist.

Wenn eine externe Deformationskraft 12 auf das Batteriegehäuse 2 einwirkt, wird dieses deformiert. Die Deformation 13 des Gehäuses 2 ist durch die gestrichelte Linie angedeutet. Aufgrund der Deformation 13 kommt es zu einem Kontakt mit im Inneren des Batteriegehäuses 2 angeordneten Batteriebestandteilen, auf die eine von der Deformation 13 ausgehende Belastungskraft ausgeübt wird. Erfindungsgemäß ist vorgesehen, zum Ableiten dieser Belastungskräfte Stützelemente 14 vorzusehen, die in dem dargestellten Ausführungsbeispiel beispielsweise Durchleitungsstifte oder Stützaugen sind. Hierdurch wird die Belastungskraft von der Platine 11 ferngehalten und diese somit geschützt. Es resultiert ein beispielhaft eingezeichneter Kraftpfad 15.

Es wird vorgeschlagen, die über das Batteriegehäuse 2 partiell eingeleitete Deformationskraft 12 an der Platine 11 vorbeizuführen oder durch die Platine 11 hindurchzuführen und das Gehäuse 2 zur Kraftverteilung großflächig auf dem Zellverbund 6 bzw. durchgehenden Stützelementen 14 abzusetzen. Die Kraftleitung erfolgt entweder über in der Platine 11 bewegliche eingelagerte Stifte oder Platten oder über auf den Platinen bereits eingearbeitete Stützaugen oder über stabile elektrische Bauelemente wie Spulen. Im Fall der eingearbeiteten Stützaugen kann die Platine 11 diese beidseitig besitzen oder die dem Gehäuse 2 zugewandte Seite ist z.B. durch Vergussmasse 8 elektrisch und Mechanisch geschützt, um großflächig die Gehäusekraft aufnehmen zu können.

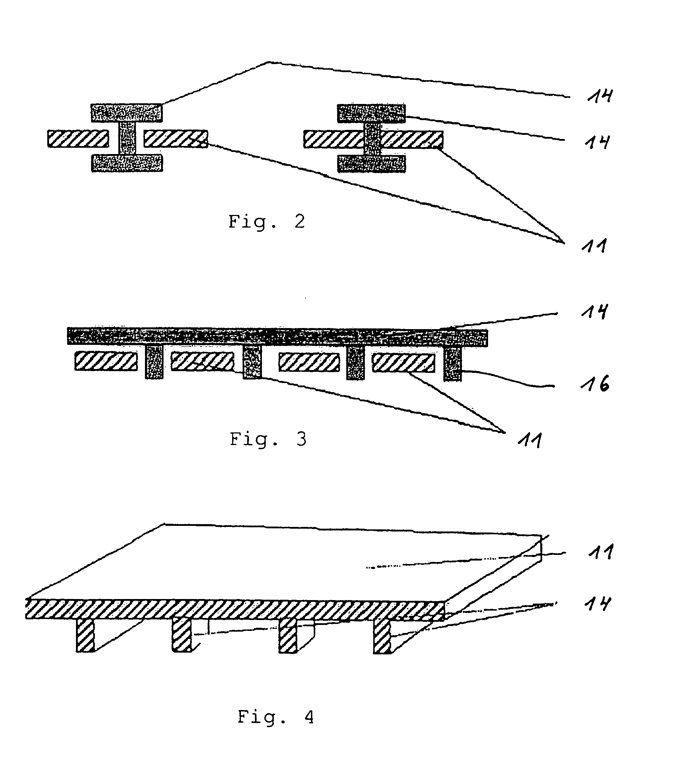

In Fig. 2 sind als Einzelelemente ausgebildete Stützelemente 14 dargestellt. In der linken Hälfte der Fig. 2 ist das Stützelement 14 beweglich in der Platine 11 gelagert. In der rechten Hälfte der Fig. 2 ist das Stützelement 14 in der Platine 11 fixiert, beispielsweise über eine Passung oder durch Einkleben.

Die Fig. 3 zeigt ein als Flächenelement ausgebildetes Stützelement 14. Es umfasst eine Stützplatte zur großflächigen Lastaufnahme und die Abstützung der Platine 11 erfolgt über durch Öffnungen in der Platine 11 hindurchgreifende Stützen 16, die beispielsweise punkt- oder linienförmig ausgebildet sein können und sich auf dem Zellverbund 6 abstützen.

Die Fig. 4 zeigt eine Platine 11 mit integrierten Stützelemente 14, deren Ausdehnung nach Bedarf bemessen ist und bei denen es sich beispielsweise auch um Stützaugen oder um Bauelemente der Platine 11, beispielsweise Spulen handeln kann.

## Patentansprüche

1. Batterie (1), insbesondere eine Lithium-Ionen-Batterie oder Nickel-Metallhydrid-Batterie, mit einem Gehäuse (2), einem in dem Gehäuse (2) angeordneten Zellverbund (6) aus Batteriezellen (5) und einer Platine (11), die im Innern des Gehäuses (2) im elektrischen Anschlussbereich (10) der Zellen zum elektrischen Verbinden der Zellen (5) angeordnet ist,
**dadurch gekennzeichnet, dass**
die Batterie (1) im Innern des Gehäuses (2) angeordnete Stützelemente (14) aufweist, mit denen im Falle einer Deformation (13) des Gehäuses (2) durch eine von außen auf das Gehäuse (2) einwirkende Deformationskraft (12), die zu einem Deformieren des Gehäuses (2) in Richtung auf die Platine (11) führt, die durch die Deformation (13) des Gehäuses (2) von dem Gehäuse (2) auf die Platine (11) ausgeübten Belastungskräfte zum Schutz der Platine (11) abgestützt werden,
dass die Stützelemente (14) zum Vorbeiführen der Belastungskräfte um die Platine (11) und/oder zum Hindurchführen der Belastungskräfte durch die Platine (11) ausgebildet sind und
dass die Stützelemente (14) für die Kraftverteilung zum großflächigen Absetzen des Gehäuses (2) auf dem Zellverbund (6) ausgebildet sind

2. Batterie (1) nach Anspruch 1, **dadurch gekennzeichnet, dass** die Stützelemente (14) zum Ableiten der Belastungskräfte auf die der Platine (11) zugewandte Seite des Zellverbunds (6) ausgebildet sind.

3. Batterie (1) nach Anspruch 1, **dadurch gekennzeichnet, dass** die Kraftleitung der Belastungskräfte mittels in der Platine (11) beweglich eingelagerter Stützelemente (14) erfolgt und/oder dass die Kraftleitung der Belastungskräfte mittels in der Platine (11) fixierter Stützelemente (14) erfolgt.

4. Batterie (1) nach Anspruch 1, **dadurch gekennzeichnet, dass** die Stützelemente (14) als Platte ausgebildet sind.

5. Batterie (1) nach Anspruch 4, **dadurch gekennzeichnet, dass** die Platte auf der von dem elektrischen Anschlussbereich der Zellen abgewandten Seite der Platine (11) angeordnet ist.

6. Batterie (1) nach Anspruch 4 oder 5, **dadurch gekennzeichnet, dass** die Platte die Platine (11) durchdringende Stützen (16) aufweist.

7. Batterie (1) nach Anspruch 1, **dadurch gekennzeichnet, dass** die Platine (11) zur Kraftleitung der Belastungskräfte auf der Platine (11) eingearbeitete oder in die Platine (11) integrierte Stützelemente (14) aufweist.

8. Batterie (1) nach Anspruch 1, **dadurch gekennzeichnet, dass** die Stützelemente (14) auf der Seite der Platine (11) angeordnet sind, die dem elektrischen Anschlussbereich (10) der Zellen (5) zugewandt ist.

9. Batterie (1) nach Anspruch 1, **dadurch gekennzeichnet, dass** die Stützelemente (14) sowohl auf der Seite der Platine (11), die dem elektrischen Anschlussbereich (10) der Zellen (5) zugewandt ist, als auch auf der Seite der Platine (11), die von dem elektrischen Anschlussbereich (10) der Zellen (5) abgewandt ist, angeordnet sind.

10. Batterie (1) nach Anspruch 1, **dadurch gekennzeichnet, dass** die Stützelemente (14) zur flächigen Lastverteilung innerhalb der Batterie (1) ausgebildet sind.

11. Batterie (1) nach Anspruch 1, **dadurch gekennzeichnet, dass** die dem Gehäuse (2) zugewandte Seite der Platine (11) mit einer Vergussmasse (8) ausgegossen ist.

12. Batterie (1) nach Anspruch 1, **dadurch gekennzeichnet, dass** die Stützelemente (14) zum Abstützen einer im wesentlichen waagrecht verlaufenden Deformationskraft (12) bzw. Belastungskraft ausgebildet und hierzu im wesentlichen in waagrechter Orientierung, bezogen auf die Einbaulage der Batterie (1), ausgerichtet sind.

## Claims

1. Battery (1), in particular lithium ion battery or nickel metal hydride battery, comprising a housing (2), a cell composite (6) of battery cells (5) arranged in the housing (2) and a printed circuit board (11) arranged in the interior of the housing (2) in the electric connection region (10) of the cells for the electric connection of the cells (5),
**characterised in that**
the battery (1) comprises support elements (14) located in the interior of the housing (2), by means of which support elements (14), in the case of a deformation (13) of the housing (2) by a deformation force (12) acting on the housing (2) from the outside and resulting in a deformation of the housing (2) in the direction towards the printed circuit board (11), the active forces applied by the housing (2) to the printed circuit board (11) as a result of the deformation of the housing (2) are supported to protect the printed circuit board (11),
**in that** the support elements (14) are designed to make the active forces bypass the printed circuit board (11) and/or to guide the active forces through the printed circuit board (11), and
**in that** the support elements (14) are designed for force distribution for the large-area placement of the housing (2) on the cell composite (6).

2. Battery (1) according to claim 1, **characterised in that** the support elements (14) are designed to deflect the active forces onto the side of the cell composite (6) which faces the printed circuit board (11).

3. Battery (1) according to claim 1, **characterised in that** the active forces are guided by means of support elements (14) which are movably installed into the printed circuit board (11), and/or **in that** the active forces are guided by means of support elements (14) which are fixed in the printed circuit board (11).

4. Battery (1) according to claim 1, **characterised in that** the support elements (14) are designed as a plate.

5. Battery (1) according to claim 4, **characterised in that** the plate is located on the side of the printed circuit board (11) which is remote from the electric connection region of the cells.

6. Battery (1) according to claim 4 or 5, **characterised in that** the plate has supports (16) passing through the printed circuit board (11).

7. Battery (1) according to claim 1, **characterised in that** the printed circuit board (11) is provided with support elements (14) built on the printed circuit board (11) or integrated into the printed circuit board (11) for guiding the active forces.

8. Battery (1) according to claim 1, **characterised in that** the support elements (14) are located on the side of the printed circuit board (11) which faces the electric connection region (10) of the cells (5).

9. Battery (1) according to claim 1, **characterised in that** the support elements (14) are located both on the side of the printed circuit board (11) which faces the electric connection region (10) of the cells (5) and on the side of the printed circuit board (11) which is remote from the electric connection region (10) of the cells (5).

10. Battery (1) according to claim 1, **characterised in that** the support elements (14) are designed for planar load distribution within the battery (1).

11. Battery (1) according to claim 1, **characterised in that** the side of the printed circuit board (11) which faces the housing (2) is filled with a potting material (8).

12. Battery (1) according to claim 1, **characterised in that** the support elements (14) are designed for supporting a substantially horizontal deformation force (12) or active force and for this purpose have a substantially horizontal orientation with respect to the installation position of the battery (1).

## Revendications

1. Batterie (1), en particulier une batterie lithium-ion ou une batterie à hydrure métallique de nickel, comprenant un boîtier (2), un ensemble cellulaire (6) disposé dans le boîtier (2) et fait d'éléments de batterie (2) et d'une carte (11) qui est disposée à l'intérieur du boîtier (2) dans la zone de connexion électrique (10) des cellules de batterie (5) pour réaliser la connexion électrique des cellules (5), **caractérisée en ce que** la batterie (1) présente des éléments de renfort (14) disposés à l'intérieur du boîtier (2), dans le cas de déformation (13) du boîtier (2) sous l'effet d'une force de déformation (12) qui agit de l'extérieur sur le boîtier (2) et conduit à une déformation du boîtier (2) en direction de la carte (11), lesdits éléments servent de renfort vis-à-vis des forces de sollicitation exercées par le boîtier sur la carte (11) en cas de déformation (13) du boîtier (2), ce qui permet de protéger la carte (11), **en ce que** les éléments de renfort (14) sont conçus pour faire passer les forces de sollicitation autour de la carte (11) et / ou les faire passer à travers la carte (11), **en ce que** les éléments de renfort (14), pour la répartition de la force, sont conçus pour déposer une grande surface du boîtier sur l'ensemble de cellules (6).

2. Batterie (1) selon la revendication 1, **caractérisée en ce que** les éléments de renfort (14) sont conçus pour dévier les forces de sollicitation sur le côté de l'ensemble de cellules (6) orienté vers la carte (11).

3. Batterie (1) selon la revendication 1, **caractérisé en ce que** l'introduction des forces de sollicitation s'effectue au moyen d'éléments de renfort (14) montés mobiles dans la carte (11) et / ou **en ce que** l'introduction des forces de sollicitation s'effectue au moyen d'éléments de renfort (14) fixés dans la carte (11).

4. Batterie (1) selon la revendication 1, **caractérisé en ce que** les éléments de renfort (14) sont conçus comme une plaque.

5. Batterie (1) selon la revendication 4, **caractérisé en ce que** la plaque est disposée sur le côté de la carte (11) qui s'éloigne de la zone de connexion électrique des cellules.

6. Batterie (1) selon la revendication 4 ou la revendication 5, **caractérisée en ce que** la plaque présente des renforts (16) qui pénètrent dans la carte (11).

7. Batterie (1) selon la revendication 1, **caractérisée en ce que** la carte (11) présente, pour l'introduction des forces de sollicitation, des éléments de renfort (14) intégrés dans la carte (11) ou insérés sur la carte (11).

8. Batterie (1) selon la revendication 1, **caractérisée en ce que** les éléments de renfort (14) sont disposés sur le côté de la carte (11) qui est orientée vers la zone de connexion électrique (10) des cellules (5).

9. Batterie (1) selon la revendication 1, **caractérisée en ce que** les éléments de renfort (14) sont disposés non seulement sur le côté de la carte (11) qui est orienté vers la zone de connexion électrique (10) des cellules (5) mais aussi sur le côté de la carte (11) qui s'éloigne de la zone de connexion électrique (10) des cellules (5).

10. Batterie (1) selon la revendication 1, **caractérisée en ce que** les éléments de renfort (14) sont conçus pour la répartition de charge sur une grande étendue à l'intérieur de la batterie (1).

11. Batterie (1) selon la revendication 1, **caractérisé en ce que** le côté de la carte (11) orienté vers le boîtier (2) est coulé avec une masse de coulage (B).

12. Batterie (1) selon la revendication 1, **caractérisée en ce que** les éléments de renfort (14) sont conçus pour supporter une force de sollicitation ou une force de déformation (12) s'étendant essentiellement à l'horizontale et pour cela dans une orientation essentiellement horizontale, sont alignés par rapport à la position de montage de la batterie (1).
